Europäisches Patentamt

European Patent Office

Office européen des brevets

(19)

(11) Numéro de publication: **0 084 394**
**A1**

(12) # DEMANDE DE BREVET EUROPEEN

(21) Numéro de dépôt: 83200045.9

(22) Date de dépôt: 12.01.83

(51) Int. Cl.³: **G 01 R 23/02**
**G 01 T 1/16**

(30) Priorité: 18.01.82 EP 82200063

(43) Date de publication de la demande:
27.07.83 Bulletin 83/30

(84) Etats contractants désignés:
AT BE CH DE FR GB IT LI LU NL SE

(71) Demandeur: ATELIERS DE CONSTRUCTIONS
ELECTRIQUES DE CHARLEROI (ACEC) Société Anonyme
54, Chaussée de Charleroi
B-1060 Bruxelles(BE)

(72) Inventeur: Maret, Jean-Pol
Rue des Ecureuils, 42
B-6269 Roselies(BE)

(74) Mandataire: Bossard, Franz et al,
ACEC - Service des Brevets Boîte Postale 4
B-6000 Charleroi(BE)

(54) Equipement de mesure et de commande de sécurité.

(57) Equipement de mesure et de commande de sécurité comprenant des compteurs du taux d'impulsions par seconde d'un train d'impulsions appliqué à son entrée, dans lequel le déverrouillage, l'arrêt, la remise à zéro ainsi que le nombre maximum ou la durée maximum de comptage de chacun des compteurs sont commandés par l'intermédiaire d'un micro-ordinateur (3) suivant des commandes inaccessibles à un opérateur, et dans lequel un micro-ordinateur (3) comprend une boucle de calcul suivi d'un convertisseur numérique-analogique (8) transformant un résultat mesuré par un compteur en un signal de sortie.

Fig.1

EP 0 084 394 A1

## EQUIPEMENT DE MESURE ET DE COMMANDE DE SECURITE.

La présente invention a pour objet un équipement de mesure et de commande de sécurité applicable dans la commande et la surveillance de processus industriels divers, par exemple dans la commande et la surveillance d'une centrale nucléaire. L'équipement suivant l'invention a pour but un appareillage de mesure et de commande coopérant avec un ordinateur ou micro-ordinateur de sécurité, non déréglable, de haute précision et d'un emploi particulièrement souple. Cet appareillage suivant l'invention peut servir à la fois à des fonctions de sécurité et des fonctions de contrôle qui dans les équipements analogiques connus sont assurées par des appareils différents.

Suivant l'invention, un équipement de mesure et de commande de sécurité comprenant un ou plusieurs compteurs de taux d'impulsions par seconde de trains d'impulsions appliqués à leurs entrées et/ou au moins une entrée pour un signal analogique suivie d'un dispositif transformant ce signal analogique en une impulsion ou un train d'impulsions est caractérisé en ce que les compteurs, notamment leur déverrouillage, arrêt, remise à zéro, ainsi que le nombre maximum ou la durée maximum de comptage de chacun des compteurs sont commandés par l'intermédiaire d'un ordinateur ou micro-ordinateur suivant des commandes inaccessibles à un opérateur, en ce que l'ordinateur comprend au moins une boucle de calcul suivie d'un convertisseur numérique-analogique transformant au moins un résultat basé sur les mesures d'un compteur en un signal de sortie et en ce que le dit ordinateur ou micro-ordinateur peut être commandé en présence d'une tension de polarisation d'autorisation de test à effectuer d'autres mesures et fournir d'autres signaux de sortie en fonction d'organes de commande et de positionnement faisant également partie de l'équipement, accessibles à un opérateur.

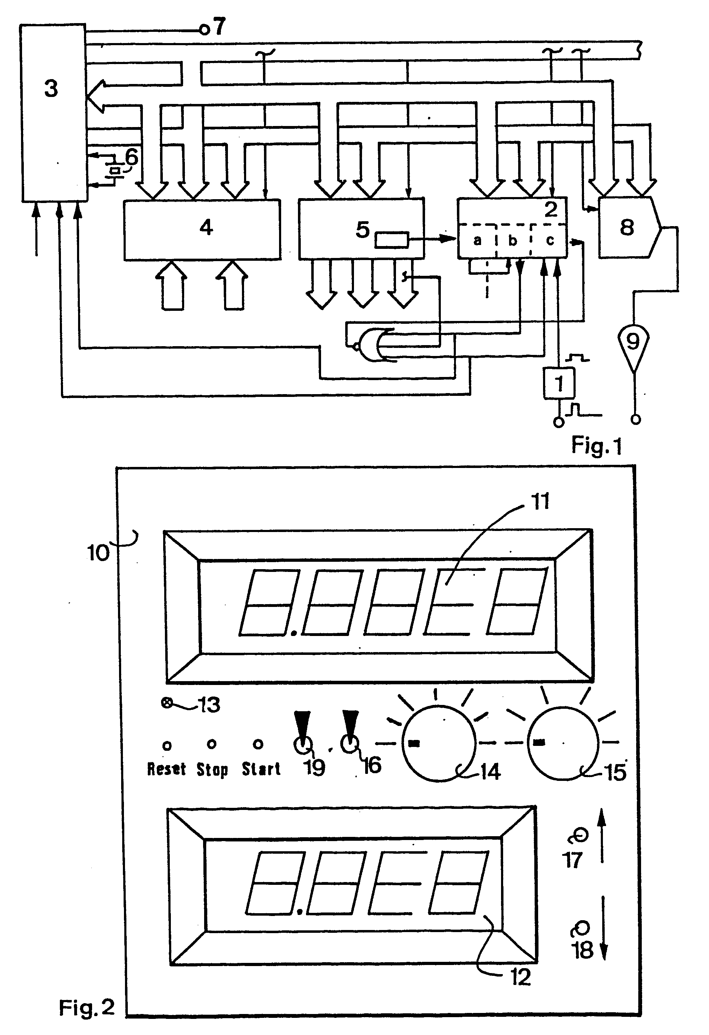

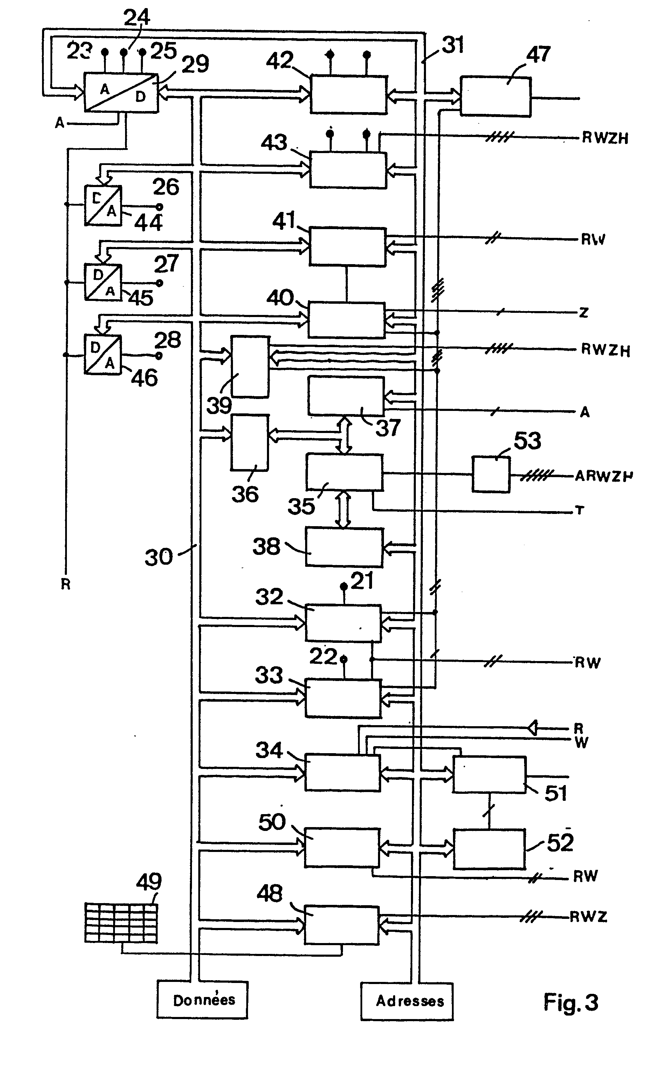

L'invention est décrite ci-dessous à l'aide d'un exemple d'une forme d'exécution en se référant au dessin annexé. Les figures 1 et 3 de ce dessin sont des schémas de principe de deux équipements différents; la figure 2 représente l'aspect d'un tableau de commande d'un équipement selon le schéma de la figure 1.

A la figure 1 est représenté un dispositif de mesure du flux neutronique au niveau de source d'une centrale nucléaire. Dans de tels

02.03/1897

dispositifs, il est connu de placer des détecteurs de neutrons à la périphérie du coeur et de transformer le signal émis par ces détecteurs en une tension approximativement proportionnelle au logarithme du taux d'impulsions par seconde à l'aide d'un appareil appelé "pompe à diodes". Une telle pompe à diodes est constituée par une mise en parallèle de plusieurs circuits différents, chacun composé d'une diode en série avec un condensateur et une résistance mis en parallèle. Le signal de sortie d'une telle pompe à diodes est approximativement proportionnel au logarithme du taux d'impulsions par seconde d'un train d'impulsions appliqué à son entrée. Ce signal de sortie est utilisé pour la commande de dispositifs de sécurité permettant par exemple de réduire l'activité du réacteur lorsque le flux neutronique de celui-ci dépasse une valeur de seuil prédéterminée.

De plus, généralement, une telle pompe à diodes est doublée d'un appareil de comptage appelé échelle de comptage et servant au contrôle, mais n'assumant pas de fonctions de sécurité.

Cet équipement connu, malgré une précision médiocre (environ 30%) est très encombrant, cher et d'un emploi peu souple.

La figure 1 montre un appareillage suivant l'invention. Dans cet appareillage, un train d'impulsions émis par un détecteur de neutrons, non représenté, est appliqué à un dispositif d'entrée 1 de mise en forme dans laquelle un temps mort $\tau$, d'une durée prédéterminée, tenant compte de la sensibilité de l'équipement, est imposé après la disparition de chaque impulsion du train d'impulsions sortant du dispositif d'entrée 1. Ainsi à la sortie du dispositif d'entrée 1, apparaît un train d'impulsions identiques en amplitude et durée dans lequel, les fronts de deux impulsions successives sont séparés au moins par une durée de temps mort, en l'occurrence choisie sensiblement plus longue que la durée d'une impulsion. Cette mise en forme permet de garantir le comptage de chaque impulsion quittant le dispositif d'entrée 1, mais réduit le nombre des impulsions comptées puisqu'elle supprime les impulsions émises pendant les temps morts. Cette réduction du nombre des impulsions comptées n'entrave pas la précision de la mesure, car dans le présent cas, les impulsions sont réparties suivant une loi statistique connue; de ce fait, le nombre d'impulsions comptées peut être utilisé pour

3  0084394

calculer un nombre corrigé équivalent aux impulsions émises par la source.

Les impulsions sortant du dispositif d'entrée 1 sont appliquées à l'entrée d'un compteur 2. Dans ce compteur 2, les impulsions sont comptées d'un côté jusqu'à ce qu'un nombre limite est atteint et/ou de l'autre côté jusqu'à ce qu'un temps limite s'est écoulé. La première limite atteinte, c'est-à-dire celle du nombre limite ou du temps limite, commande l'arrêt de l'opération de comptage. Suivant le régime choisi, cet arrêt est définitif jusqu'à nouvel ordre (régime manuel) ou suivi immédiatement d'une remise à zéro et de continuation d'un nouveau cycle de comptage (régime automatique). Le choix de ces deux régimes se fait à travers un micro-ordinateur 3 coopérant avec des dispositifs auxiliaires, en particulier des mémoires, par exemple, une mémoire de programme 4 du type EPROM et une mémoire de données 5 du type RAM. Au micro-ordinateur 3 est associé une horloge à haute fréquence comprenant un quartz 6 taillé pour une fréquence propre de plusieurs Mégahertz. Les oscillations émises par ce quartz sont comptées dans le micro-ordinateur 3 et constituent la base de temps d'une horloge de l'équipement de mesure. En l'occurrence, cet équipement de mesure fonctionne comme icto-mètre et permet de sélectionner les temps de comptage et les durées de temps mort.

En fait, le compteur 2 est composé d'un compteur d'impulsions d'horloge 2a d'un compteur d'impulsions de mesure 2c et d'un diviseur 2b délivrant une valeur représentant la gamme choisie du taux d'impulsions par seconde.

Dans la mémoire de programme 4 sont enregistrés les programmes de micro-ordinateur permettant de commander différents régimes de fonctionnement prévus. Parmi ces régimes, celui de la commande de sécurité est le plus important, il est soustrait à toutes les possibilités de réglage et protégé ainsi d'une intervention arbitraire d'un opérateur. Cependant, en présence d'une commande d'autorisation de test matérialisée par une tension de polarisation de test, T apparaissant à une borne 7, le micro-ordinateur peut accepter d'exécuter d'autres fonctions. Cette tension de polarisation de test T est délivrée par le tableau de commande principal de la centrale nucléaire, à la demande d'un opérateur pour autant que les conditions de fonctionnement de la .centrale permettent la suspension temporaire du régime de commande de sécurité. Une suppression de cette tension de polarisation de test T rétablit sans retard, automatiquement, le régime de commande de sécurité. Dans le cas présent, ce régime est un régime automatique caractérisé par le choix d'un temps mort déterminé, le choix d'un nombre maximum de comptage et d'un temps maximum de comptage déterminés et le choix d'entrées prédéterminées. Le résultat fourni par le compteur, en l'occurrence, le taux de comptage mesuré en impulsions par seconde est traité dans une boucle de calcul du micro-ordinateur pour produire un signal de sortie utilisable. Dans le présent cas, le taux d'impulsions par seconde est corrigé suivant une formule appropriée, c'est-à-dire, puisque les impulsions apparaissent aléatoirement selon une distribution de Poisson, le taux de comptage corrigé N est déterminé suivant la formule

$$N = N_o \ (1 + N_o \tau)$$

où $N_o$ signifie le taux enregistré par le compteur 2 et $\tau$ le temps mort choisi. L'application de cette formule est très sûre puisqu'on a déterminé artificiellement, de manière très précise, le temps mort $\tau$ dans le dispositif d'entrée 1.

Grâce à une table de logarithmes enregistrée dans la mémoire de programme et la conception particulière de la boucle de calcul dans l'ensemble mémoire de programme 4 et micro-ordinateur 3, cet ensemble calcule le logarithme du taux de comptage N et livre la valeur de ce logarithme à l'entrée d'un convertisseur numérique/analogique 8 suivi d'un amplificateur 9 de tension dont la sortie fournit une tension par exemple entre 0 et 10 Volt, 0 Volt représentant un taux de comptage $N = 1$ coup/s et 10 volts un taux de comptage $N = 10^6$ coups/s. Dans l'intervalle entre 1 et $10^6$ coups/s, la tension de sortie de l'amplificateur 9 est égale à $1,667 \log N$ volts. La tension de seuil de réponse d'une intervention de commande de sécurité peut être choisie à volonté et correspond à un taux de comptage déterminé entre 1 et $10^6$ coups/s.

L'état du compteur 2 est affiché par exemple sur un écran lumineux 11 d'un panneau de commande frontal 10 de l'équipement de mesure et de commande (fig.2). L'affichage peut se faire de n'importe quelle manière, par exemple comme de coutume sur une machine à calculer de poche. Un deuxième écran lumineux 12 permet d'afficher, par exemple, la durée du temps mort choisie.

Pour le cas de mesures d'essai, pour lequel la présence de la tension de polarisation d'autorisation de test T est nécessaire à la borne 7, plusieurs organes de commande sont prévus sur le panneau 10; une lampe témoin 13 qui indique la présence ou l'absence de la tension de polarisation de test un sélecteur 14 du nombre maximum à compter, un sélecteur 15 de la durée maximum de comptage, un commutateur 16 pour l'affichage normal ou l'affichage de test: l'affichage normal étant celui déjà écrit. Dans la position "affichage de test" du commutateur 16, l'écran 12 ne montre pas la valeur du temps mort, mais par exemple la valeur de la tension de sortie de l'amplificateur 9. Deux boutons 17 et 18 permettent de commander, suivant la position du commutateur 16, soit la modification du temps mort, soit la modification de la tension de sortie de l'amplificateur 9.

Un autre commutateur 19 permet de sélectionner entre un régime manuel (arrêt après chaque cycle de comptage) et un régime automatique (le comptage continue après chaque cycle et remise à zéro). Trois boutons "Reset", "Stop", "Start", permettent de commander respectivement la remise à zéro, l'arrêt du comptage et le déverrouillage du compteur.

Ces différents éléments de commande n'interviennent pas directement dans les circuits, mais fournissent seulement des états d'entrée soit à la mémoire de programme 4, soit au micro-ordinateur 3. En présence de la tension de polarisation de test à la borne 7, l'ordinateur interroge les états d'entrée commandés par ces organes et opère suivant le programme correspondant, sélectionné par l'ensemble des états d'entrée. Dès que la tension de polarisation disparaît à la borne 7, l'ordinateur opère suivant le programme de sécurité, inaccessible à l'opérateur, quel que soit le positionnement des organes 14 à 19.

Un autre appareil, suivant la figure 3, se présente sous forme d'un châssis électronique équipé de modules fonctionnels enfichables. Chaque module est réalisé au moyen de composants du commerce, en l'occurrence à 8 bits. Les interconnexions sont réalisées par câblage.

Des entrées 21, 22 pour trains d'impulsions (impulsions rectangulaires récurrentes ou erratiques variant dans une gamme de fréquence déterminée, par exemple entre 1 Hz et 1 MHz) et des entrées analogiques 23, 24, 25 pour des signaux de grandeur déterminée, par exemple des tensions entre 1 et 10 volts sont prévues. Des sorties analogiques 26, 27, 28 (par exemple aussi des tensions entre 1 et 10 volts) sont accessibles directement et peuvent représenter une grandeur résultant d'un calcul. Des sorties numériques sont matérialisées dans des ensembles périphériques de diverses natures sous forme d'affichages ou de signaux de commande.

Les entrées analogiques 23, 24, 25 sont appliquées à un ensemble convertisseur analogique-numérique 29 dont la sortie est reliée à un bus de données 30. Le raccordement du convertisseur 29 à un bus d'adresses 31 permet d'envoyer les données entrant par ce convertisseur à des endroits appropriés.

Les entrées 21, 22 pour trains d'impulsions constituent des entrées d'ensembles compteurs 32, 33 reliées également au bus des données 30 d'une part et au bus des adresses 31 d'autre part. Chaque ensemble 32, 33 est composé de trois compteurs, non représentés en détail, dont les valeurs enregistrés permettent de déterminer, comme pour l'exemple de la figure 1, la fréquence moyenne d'un train d'impulsions arrivant à l'entrée à l'intérieur d'une gamme appropriée.

Une mémoire 34 peut être constituée d'un nombre approprié de sous-ensembles chacun composé d'éléments EPROM et/ou d'éléments RAM choisis en fonction des mesures ou commandes à exécuter par l'appareil. La mémoire 34 est reliée au bus de données 30 et au bus des adresses 31. Elle peut enregistrer des données de base invariables et des données variables en cours du processus à surveiller ou à commander, ainsi que des résultats intermédiaires de calcul.

Les calculs et autres traitements de données sont réalisés dans une unité de calcul centrale 35. Cette unité de calcul 35, un ordinateur ou micro-ordinateur, est relié au bus des données 30 et au bus des adresses 31, de préférence par l'intermédiaire de circuits tampons 36, 37, 38. Certains calculs à effectuer avec une grande rapidité sont confiés à un calculateur arithmétique 39, conçu pour des algorithmes particuliers.

L'association de l'unité de calcul 35 avec un calculateur arithmétique 39 rend possible le traitement numérique et la surveillance des signaux d'entrée 21 à 25 dans un intervalle de temps court, ce qui permet de suivre de façon permanente l'évolution du processus industriel surveillé.

Une unité d'interface programmable 40 pour des périphériques permet d'assurer des fonctions telles que le choix de la cadence d'une horloge mère 41, la commande des unités de comptage 32, 33, des tests de fin de mesure de fréquence, ainsi que l'allumage de lampes témoins etc.

L'horloge mère 41 permet, au moyen de mini-interrupteurs, non représentés, de choisir une vitesse de transmission entre par exemple 100 et 10000 bauds.

Un module d'interface 42 vers une console de commande et un module d'interface 43 vers une imprimante assurent les liaisons entre l'unité de calcul centrale 35, le convertisseur analogique-numérique 29 d'entrée et des convertisseurs numérique-analogique de sortie 44, 45, 46. Il va de soi que le nombre de ces convertisseurs 29, 44, 45, 46 ainsi que le nombre de leurs entrées ou sorties ne sont pas limités. Un décodeur d'adresses 47 coopère avec les modules d'interface 42 et 43. Un module d'interface 48 vers des afficheurs 49 situés dans un panneau de l'appareil coopère avec une horloge 50 servant à la synchronisation.

Dans le but de permettre un choix correct parmi un grand nombre de sous-ensembles à éléments ROM et/ou RAM de la mémoire 34, un sélecteur, en l'occurrence composé de deux modules de sélecteur 51 et 52 peut être prévu.

On reconnaît sur la figure 3 aussi l'existence d'un bus de commande, représenté par un ensemble de conduites dessinées de manière dispersées, généralement à plusieurs conducteurs, véhiculant des signaux de commande, par exemple A (déverrouillage d'adresse), L (lecture), E (enregistrement), D (direction d'adressage vers mémoires ou vers périphériques), Z (mise à zéro), H (impulsions d'horloge de base) et éventuellement d'autres. La liaison de ce bus de commande à l'ordinateur 35 se fait de préférence à travers un dispositif tampon 53.

L'appareil suivant la figure 3 fonctionne comme suit: à la mise sous tension, l'appareil effectue d'abord une mise à zéro automatique et démarre à partir d'un jeu d'instructions et de paramètres contenus dans la mémoire 34 dans des éléments ROM et transférés dans des éléments RAM.

Deux modes de fonctionnement sont alors possibles suivant la présence ou l'absence d'un signal T d'autorisation extérieure de test appliqué à l'unité de calcul centrale 35. En présence du signal T toutes les commandes et toutes les entrées 21 à 25 et données enregistrées sont accessibles via l'unité de calcul centrale 35 à un opérateur qui peut les utiliser à son gré pour des contrôles ou mesures choisis. L'accès peut se faire notamment via l'interface 42 et une console ou un télétype de poche au moyen d'un procédé conversationnel. Lors d'un tel procédé conversationnel des valeurs contenues dans des éléments ROM de la mémoire 34 peuvent être transférées dans des éléments RAM et l'ensemble des paramètres utilisés y compris ceux introduits pour les besoins immédiats, ainsi que les valeurs calculées peuvent être affichées soit sur l'écran, soit par l'imprimante. En l'absence du signal T, au contraire, le mode de fonctionnement est imposé et est exécuté automatiquement. Il est limité à des fonctions de sécurité pour lesquels l'appareil a été conçu spécialement. Le libre accès à l'unité de calcul centrale 35, et par la suite aux données d'entrée 21 à 25 au calculateur 39 et aux données enregistrées dans la mémoire 34 est alors interdit et rendu impossible.

Les données utilisées par l'appareil en régime "protection" sont les dernières valeurs enregistrées et les constantes emmagasinées dans la mémoire 34 dans des éléments ROM et transférés en RAM au moment de la disparition du signal d'autorisation T ou de la mise sous tension initiale.

Un appareil suivant la figure 3 peut être utilisé par exemple comme réactimètre destiné à mesurer la réactivité d'une centrale nucléaire. Cette réactivité n'est pas mesurable directement, mais peut être appréciée au moyen d'un calcul effectué à partir de grandeurs auxquelles on a accès.

On part des équations cinétiques du réacteur supposé à plusieurs combustibles j pour arriver à une expression de la réactivité $\varrho(t)$ dans laquelle intervient la puissance instantanée $P(t)$ du réacteur qui est un paramètre accessible sous forme d'un courant de sortie d'une chambre

0084394

d'ionisation soumise au flux neutronique. Ce courant est transformé en une suite d'impulsions au moyen d'un circuit d'interface et appliqué à l'entrée d'un des ensembles compteurs. Pour le calcul de la réactivité ci-dessous, aucune entrée analogique n'est utilisée. Toutes les constantes sont enregistrées dans des mémoires ROM de la mémoire 34.

$$\varrho(t) = \beta\left[1 - \frac{2\frac{Sl}{\beta}}{P(t)+P(t-\tau)} - \sum_{i=1}^{6}\frac{T_i(t)}{P(t)+P(t-\tau)}\right]$$

avec $P(t)$ : puissance neutronique à l'instant t

$P(t-\tau)$ : puissance neutronique à l'instant $t - \tau$

$\tau$ : intervalle de temps d'échantillonnage de la puissance neutronique

$T_i(t)$ : $T_i(t - \tau) \times R_i + 2.a_1\ P(t).(1 - R_i)$

$T_i(0) = 2\ a_i\ P$ initial où $P$ initial représente la valeur instantanée de $P(t)$ au moment où on démarre le calcul;

$R_i = \exp(-\lambda_1.\tau)$

$$a_i = \frac{\beta'_i}{\beta}\ ) \quad \beta'_i = \sum_{j=1}^{3}\alpha_j\beta_{ij}\ ; \quad \beta = \sum_{j=1}^{3}\alpha_j\beta_j\ ; \quad \beta_j = \sum_{i=1}^{6}\beta_{ij}$$

$\beta_{i.j}$ : fraction des neutrons différés dus à une famille i dans le combustible j. En l'occurrence trois combustibles sont pris en considération: U235, U238, PT239. Pour chacun des combustibles on distingue 6 familles de fractions de neutrons différés.

$\alpha_j = \dfrac{f_j\,v_j}{\sum_j f_j\,v_j}$ : proportion des neutrons différés qui viennent du combustible j

$f_j$ : proportion des fissions ayant lieu dans le combustible en début et fin de cycle.

$v_j$ : nombre total moyen de neutrons produits par fission d'un atome du combustible j.

$\lambda_i$ : vie moyenne des précuseurs des neutrons différés de la famille i

$Sl$ : nombre de neutrons émis par la source et par seconde.

Voici l'organigramme complet du calcul de $\varrho(t)$:

0084394

DEBUT

INTRODUCTION DES CONSTANTES

CALCUL DE $\beta$ ET DES ai

INTRODUCTION DE S1  — Terme source

INITIALISATION    Ti(o) = 2.ai P instantané

CHOIX DE $\tau$

CALCUL DES Ri ET DES $\Delta$i        $\Delta i = 2ai (1-Ri)$

ENTREE DE P (t)

i = 1

CALCUL DE Ti(t)    $Ti(t) = Ti(t - \tau) Ri + \Delta i \ P(t)$

i = i + 1

NON  —  i=6  —  OUI

$\sum_i Ti(t) + \frac{S\ell}{\beta}$

$$\rho (t) = \beta \left\{ 1 - \frac{1}{P(t) + P(t-\tau)} \left[ \sum_i T_i - \frac{S\ell}{\beta} \right] \right\}$$

AFFICHAGE ET SORTIE DE $\rho(t)$

PREPARATION DU PAS SUIVANT
Ti (t-r) = Ti(t);   P (t- ) = P(t)

NOUVELLE INITIALISATION OU FIN  — NON / OUI

INITIALISATION NOUVELLE  — OUI / NON — FIN

## REVENDICATIONS

1.  Equipement de mesure et de commande de sécurité comprenant un ou plusieurs compteurs (2; 32,33) de taux d'impulsions par seconde de trains d'impulsions appliqués à leurs entrées (1; 21, 22) et/ou au moins une entrée (23,24,25) pour un signal analogique suivie d'un dispositif (29) transformant ce signal analogique en une impulsion ou un train d'impulsions,

caractérisé en ce que les compteurs (2; 32,33), notamment leur déverrouillage, arrêt, remise à zéro, ainsi que le nombre maximum ou la durée maximum de comptage de chacun des compteurs sont commandés par l'intermédiaire d'un ordinateur ou micro-ordinateur (3,35) suivant des commandes inaccessibles à un opérateur, en ce que l'ordinateur (3,35) comprend au moins une boucle de calcul suivi d'un convertisseur numérique-analogique (8, 44,45,46) transformant au moins un résultat basé sur les mesures d'un compteur (2; 32,33) en un signal de sortie (9; 26,27,28) et en ce que le dit ordinateur ou micro-ordinateur (3; 35) peut être commandé, en présence d'une tension de polarisation d'autorisation de test (T), à effectuer d'autres mesures et fournir d'autres signaux de sortie en fonction d'organes de commande et de positionnement (14 à 19; 21 à 25) faisant également partie de l'équipement, accessibles à un opérateur.

2.  Equipement suivant la revendication 1, caractérisé en ce qu'il comprend un étage d'entrée (1) dans lequel les impulsions à mesurer sont normalisées en durée et amplitude et fournies à un compteur (2) avec un temps mort déterminé au moyen d'un dispositif de sélection (14,15).

3.  Equipement suivant une des revendications 1 et 2, caractérisé en ce qu'une mémoire de programme (4) du type EPROM et une mémoire de données (5) du type RAM ainsi qu'une horloge à haute fréquence sont associés au micro-ordinateur (3).

4.  Equipement suivant une des revendications précédentes caractérisé en ce que le micro-ordinateur (3) comprend une boucle de calcul de correction du temps mort et en ce que la mémoire (4) comprend une table de logarithmes pour fournir un signal de sortie proportionnel au logarithme du résultat mesuré par le compteur et corrigé par le micro-ordinateur.

02.02/1897

5.    Equipement suivant une des revendications précédentes, caractérisé en ce que des dispositifs d'affichage (11,12) et leurs valeurs d'entrée sont également raccordés au micro-ordinateur (3) et commandés par ce dernier.

6.    Equipement suivant la revendication 1, caractérisé en ce que l'ordinateur (35) est relié à une unité de calcul arithmétique agencé pour effectuer rapidement certains calculs prédéterminés.

7.    Equipement suivant la revendication 1 et 6, caractérisé en ce qu'il est agencé pour effectuer le calcul de la réactivité d'une centrale nucléaire.

Fig. 1

Fig. 2

0084394

Fig.3

0084394

Office européen
des brevets

**RAPPORT DE RECHERCHE EUROPEENNE**

Numéro de la demande

EP 83 20 0045

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| | --- | | G 01 R 23/02 |
| A | SIEMENS REVIEWS, vol. 45, no. 1, janvier 1978, pages 43-47; A.BAYATI: "Digital differential pulse ratemeter with logarithmic characteristic for monitoring radiation in nuclear plants" *Page 43, colonne de gauche, jusqu'à la fin du deuxième alinéa de la colonne de droite* | 1 | G 01 T 1/16 |
| | --- | | |
| A | HEWLETT PACKARD JOURNAL, vol. 30, no. 1, janvier 1979, pages 2-11; L.W.MASTERS et al.: "A low-cost, microprocessor-based, 100-MHz universal counter". *Page 4, dernier alinéa de la colonne de droite; page 5; figure 3* | 1-3,5 | |
| | --- | | DOMAINES TECHNIQUES RECHERCHES (Int. Cl. ³) |
| A | IEEE TRANSACTIONS ON INDUSTRIAL ELECTRONICS AND CONTROL INSTRUMENTION, vol. IECI-25, no. 2, mai 1978, pages 112-116; D.P.EICHENLAUB: "A microcomputer-based radiation monitoring system for nuclear power plants". *Page 113, paragraphe B, colonne de gauche et colonne de droite; figures 2-3* | 1 | G 01 R G 01 T |
| | ----- | | |

Le présent rapport de recherche a été établi pour toutes les revendications

| Lieu de la recherche | Date d'achèvement de la recherche | Examinateur |
|---|---|---|
| LA HAYE | 18-03-1983 | KUSCHBERT D.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

OEB Form 1503. 03.82